(19) Europäisches Patentamt / European Patent Office / Office européen des brevets

(11) **EP 3 678 166 A1**

(12) **EUROPEAN PATENT APPLICATION**
published in accordance with Art. 153(4) EPC

(43) Date of publication:
08.07.2020 Bulletin 2020/28

(51) Int Cl.:
*H01L 21/52* [(2006.01)]     *H01L 25/07* [(2006.01)]
*H01L 25/18* [(2006.01)]

(21) Application number: 18850274.4

(22) Date of filing: 28.08.2018

(86) International application number:
PCT/JP2018/031678

(87) International publication number:
WO 2019/044798 (07.03.2019 Gazette 2019/10)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 28.08.2017  JP 2017163407
11.07.2018  JP 2018131435

(71) Applicant: Hitachi Chemical Co., Ltd.
Chiyoda-ku
Tokyo 100-6606 (JP)

(72) Inventors:
• KOSEKI Yuta
Tokyo 100-6606 (JP)
• HONDA Kazutaka
Tokyo 100-6606 (JP)

(74) Representative: Hoffmann Eitle
Patent- und Rechtsanwälte PartmbB
Arabellastraße 30
81925 München (DE)

(54) **METHOD FOR MANUFACTURING POWER SEMICONDUCTOR DEVICE, SHEET FOR HOT PRESSING, AND THERMOSETTING RESIN COMPOSITION FOR HOT PRESSING**

(57) Disclosed is a method for manufacturing a power semiconductor device including a wiring substrate and a power semiconductor element mounted on the wiring substrate. The method includes a step of heating and pressuring a laminate, which has a wiring substrate, a power semiconductor element, and a sintering material containing metal particles, by sandwiching the laminate with a stage and a press-bonding head to thereby electrically connect the wiring layer and the electrode through a sintered metal layer formed by sintering the sintering material. The laminate is heated and pressured in a state where a sheet for hot pressing having a thermosetting resin layer is interposed between the laminate and the press-bonding head.

*Fig.3*

## Description

### Technical Field

The present invention relates to a method for manufacturing a power semiconductor device, a sheet for hot pressing used for manufacturing a power semiconductor device, and a thermosetting resin composition for hot pressing used for forming a sheet for hot pressing.

### Background Art

In the case of mounting a power semiconductor element on a wiring substrate to manufacture a power semiconductor device in which the power semiconductor element is connected to the wiring substrate by a conductive material, generally, the power semiconductor element is mounted on the wiring substrate by undergoing a step of heating and pressuring the power semiconductor element one by one by hot pressing. Since the power semiconductor device is expected to be used in a high temperature region, a sintering material containing metal particles and having high heat resistance may be applied as a conductive material of electrically connecting an electrode of the power semiconductor element and the wiring substrate (for example, Patent Literature 1).

### Citation List

### Patent Literature

Patent Literature 1: Japanese Unexamined Patent Publication No. 2016-143685

## Summary of Invention

### Technical Problem

However, in the case of mounting the power semiconductor element on the wiring substrate through the sintering material containing metal particles, defects such as peeling of a part of a connection portion and sparseness of a part of a sintered metal layer formed by sintering the sintering material may occur. In particular, when a laminate including a plurality of power semiconductor elements is collectively heated and pressured, a problem arises in that connection reliability is insufficient in a high proportion of the plurality of power semiconductor elements. For these reasons, it is actually very difficult to stably produce a power semiconductor device having sufficient connection reliability by a method including a step of collectively mounting a plurality of power semiconductor elements on a wiring substrate.
In this regard, an object of one aspect of the present invention is to provide a method by which a power semiconductor element can be mounted on a wiring substrate with high connection reliability in the case of mounting the power semiconductor element on the wiring substrate through a sintering material containing metal particles. Further, the present invention also provides a sheet for hot pressing used in the relevant method and a thermosetting resin composition for hot pressing used for forming a sheet for hot pressing.

### Solution to Problem

One aspect of the present invention relates to a method for manufacturing a power semiconductor device including a wiring substrate and a power semiconductor element mounted on the wiring substrate. The method according to one aspect of the present invention includes a step of heating and pressuring a laminate, which has a wiring substrate having an insulating substrate and a wiring layer provided on the insulating substrate, a power semiconductor element having an electrode, and a sintering material containing metal particles, the power semiconductor element being disposed so that the wiring layer and the electrode face each other, the sintering material being interposed between the wiring layer and the electrode facing each other, by sandwiching the laminate with a stage and a press-bonding head to thereby electrically connect the wiring layer and the electrode through a sintered metal layer formed by sintering the sintering material. In the above step, the laminate is heated and pressured in a state where a sheet for hot pressing having a thermosetting resin layer is interposed between the laminate and the press-bonding head. The thermosetting resin layer is a resin layer containing a thermosetting resin.
By heating and pressuring a laminate having a wiring substrate and a power semiconductor element in a state of interposing a sheet for hot pressing having a thermosetting resin layer between the laminate and a press-bonding head, the power semiconductor element can be mounted on the wiring substrate with high connection reliability.
The thermosetting resin layer may contain a (meth)acrylate compound and a polymerization inhibitor. A content of the polymerization inhibitor may be 0.01 to 10 parts by mass with respect to 100 parts by mass of a content of the (meth)acrylate compound.

When the sheet for hot pressing having a thermosetting resin layer containing a (meth)acrylate compound is used after being stored for a long period of time, a power semiconductor device may be difficult to be stably manufactured by the hot pressing. According to the method, even after the sheet for hot pressing is stored for a long period of time, a power semiconductor device can be stably manufactured.

In the step of electrically connecting the wiring layer and the electrode, a plurality of the laminates each having one semiconductor power element or one or a plurality of the laminates having a plurality of the power semiconductor elements disposed one wiring substrate may be heated and pressured by being sandwiched with a pair of the stage and the press-bonding head.

By collectively heating and pressuring a laminate including a plurality of power semiconductor elements disposed on a wiring substrate through a sintering material, if the plurality of power semiconductor elements can be simultaneously mounted on the wiring substrate, a power semiconductor device can be manufactured with high efficiency. In the case of collectively connecting the plurality of power semiconductor elements, a pressure is not uniformly applied to these power semiconductor elements, and thus a problem arises in that the connection state is likely to be defective in some of the power semiconductor elements due to unevenness of pressure. Even in such a case, by using the sheet for hot pressing having a thermosetting resin layer, unevenness of pressure is alleviated, and a power semiconductor device having sufficient connection reliability can be stably manufactured.

Another aspect of the present invention relates to a sheet for hot pressing having a thermosetting resin layer. This sheet for hot pressing is used for interposing between the laminate and the press-bonding head in the above method. In other words, another aspect of the present invention relates to an application of a sheet having a thermosetting resin layer for interposing between the laminate and the press-bonding head in the above method or an application of the sheet having a thermosetting resin layer for interposing between the laminate and the press-bonding head in the above method to thereby manufacture a power semiconductor device.

A thickness of the thermosetting resin layer may be 20 μm or more.

The sheet for hot pressing may further have a release sheet provided on one side or both sides of the thermosetting resin layer.

The thermosetting resin layer may contain a (meth)acrylate compound as the thermosetting resin, and the thermosetting resin layer may further contain a polymerization initiator. The thermosetting resin layer may contain a (meth)acrylate compound as the thermosetting resin, and the thermosetting resin layer may further contain a polymerization inhibitor. The thermosetting resin layer may contain an epoxy compound as the thermosetting resin and the thermosetting resin layer may further contain a curing agent for the epoxy compound.

Still another aspect of the present invention relates to a thermosetting resin composition for hot pressing containing a thermosetting resin, the thermosetting resin composition for hot pressing being used for forming the thermosetting resin layer of the sheet for hot pressing described above. In other words, still another aspect of the present invention relates to an application of a thermosetting resin composition containing a thermosetting resin for forming the thermosetting resin layer of the sheet for hot pressing described above. The thermosetting resin composition may contain a (meth)acrylate compound as the thermosetting resin, and the thermosetting resin composition may further contain a polymerization initiator. The thermosetting resin composition may contain an epoxy compound as the thermosetting resin and the thermosetting resin composition may further contain a curing agent for the epoxy compound. This thermosetting resin composition may further contain a solvent.

**Advantageous Effects of Invention**

According to the present invention, a power semiconductor element can be mounted on a wiring substrate with high connection reliability. In particular, even in the case of collectively mounting a plurality of power semiconductor elements on a wiring substrate, a power semiconductor device can be manufactured with high connection reliability while suppressing a variation in connection state. For example, in the case of mounting a plurality of power semiconductor elements on one wiring substrate, since the height of the power semiconductor elements differs for each power semiconductor element, when these power semiconductor elements are collectively heated and pressured, unevenness of pressure easily occurs; however, even in such a case, according to the method using the sheet for hot pressing of the present invention, a plurality of power semiconductor elements can be collectively mounted on a wiring substrate with high connection reliability. When the power semiconductor elements are heated and pressured one by one on one wiring substrate, in addition to low productivity, heat is also transmitted around the power semiconductor elements to be heated and pressured, and thus there is also a problem in that this heat affects the characteristics of a sintered metal layer connecting the power semiconductor elements. According to the method of the present invention, such a problem can also be avoided.

According to some aspects of the present invention, in the case of manufacturing a power semiconductor device, which has a power semiconductor element mounted on a wiring substrate through a sintering material containing metal particles, using a sheet for hot pressing having a thermosetting resin layer containing a (meth)acrylate compound, a method by which a power semiconductor device can be stably manufactured even after a sheet for hot pressing is stored for a long period of time is provided.

**Brief Description of Drawings**

FIG. 1 is a cross-sectional view illustrating an embodiment of a method for manufacturing a power semiconductor device.
FIG. 2 is a cross-sectional view illustrating an embodiment of a method for manufacturing a power semiconductor device.
FIG. 3 is a cross-sectional view illustrating an embodiment of a method for manufacturing a power semiconductor device.
FIG. 4 is a cross-sectional view of a power semiconductor device according to an embodiment.
FIG. 5 is a cross-sectional view of a sheet for hot pressing according to an embodiment.
FIG. 6 is a cross-sectional image obtained by ultrasonic observation of a semiconductor element-mounted substrate of Example 1-1.
FIG. 7 is a cross-sectional image obtained by ultrasonic observation of a semiconductor element-mounted substrate of Comparative Example 1-1.

**Description of Embodiments**

Hereinafter, embodiments of the present invention will be described with reference to the drawings as appropriate. However, the present invention is not limited to the following embodiments. In the following embodiments, the constituent elements (including an elemental step or the like) are not always indispensable unless otherwise specified. The same applies to numerical values and ranges thereof, and the present invention is not limited thereby. Further, the sizes of members in the drawings are conceptual, and the relative size relationships between the members are not limited to those illustrated in the drawings.
In the present specification, the term "step" includes not only a separate step but also a step that is not clearly distinguished from other steps as long as the object of the step is obtained therefrom.
In the present specification, a numerical range expressed by using "to" includes the numerical values before and after "to" as the minimum value and the maximum value, respectively.
In the present specification, in a case where a plurality of substances corresponding to each component in a composition exist, a content of each component in the composition means the total content of the plurality of substances that exist in the composition, unless otherwise specified.
In the present specification, in a case where a plurality of particles corresponding to each component in a composition exist, a particle size of each component in the composition means a value obtained from a mixture of the plurality of particles that exist in the composition, unless otherwise specified.
In the present specification, the term "layer" includes, when a region where the layer exists is observed, not only a case where the layer is formed over the entirety of the region, but also a case where the layer is formed only on a part of the region.

Method for manufacturing power semiconductor device

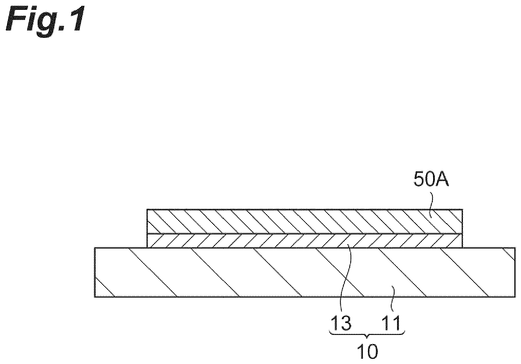

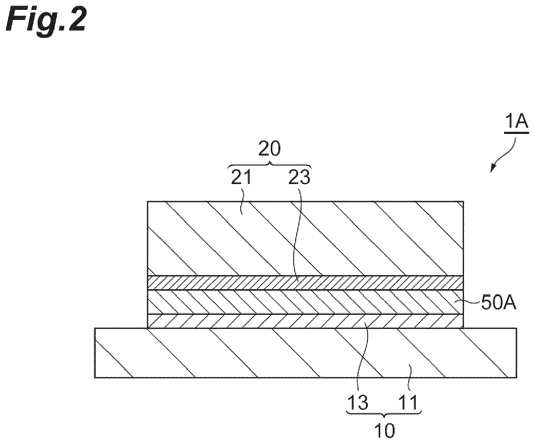

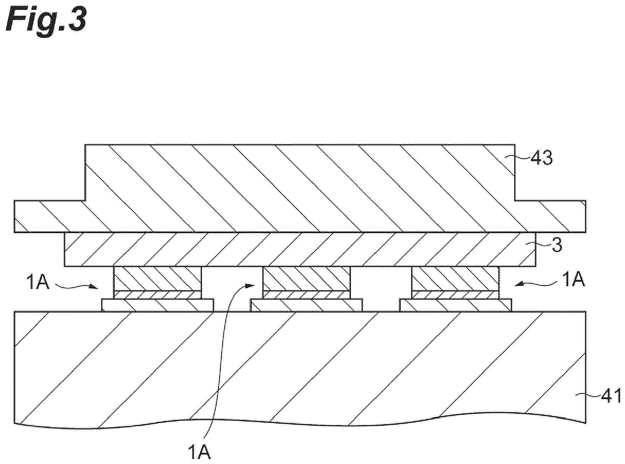

FIGS. 1, 2, and 3 are cross-sectional views illustrating an embodiment of a method for manufacturing a power semiconductor device. The method illustrated in FIGS. 1 to 3 includes collectively heating and pressuring a plurality of laminates each including one power semiconductor element by sandwiching the plurality of the laminates with a pair of a stage and a press-bonding sheet.
First, as illustrated in FIG. 1, a wiring substrate 10 having an insulating substrate 11 and a wiring layer 13 provided on the insulating substrate 11 is prepared and a sintering material 50A is supplied onto the wiring layer 13.
Next, as illustrated in FIG. 2, a power semiconductor element 20 having an element main body 21 and an electrode 23 provided on a back surface which is one main surface of the element main body 21 is disposed on the sintering material 50A so that the wiring layer 13 and the electrode 23 face each other to thereby form a laminate 1A. In the laminate 1A, the sintering material 50A is interposed between the wiring layer 13 and the electrode 23 facing each other.
Next, as illustrated in FIG. 3, a plurality of the laminates 1A are disposed on a stage 41, and a sheet for hot pressing 3 having a thermosetting resin layer is interposed between the plurality of the laminates 1A and a press-bonding head 43. In this state, heating and pressuring are performed by simultaneously sandwiching the plurality of the laminates 1A with a pair of the stage 41 and the press-bonding head 43. The sintering material 50A is sintered by heating and pressuring to form a sintered metal layer. In the process of heating and pressuring, the thermosetting resin layer of the sheet for hot pressing 3 is typically cured after being in a state of having a certain degree of fluidity once. After heating and pressuring, the sheet for hot pressing 3 is removed. According to this method, a plurality of power semiconductor elements can be collectively mounted on a wiring substrate by heating and pressuring once.

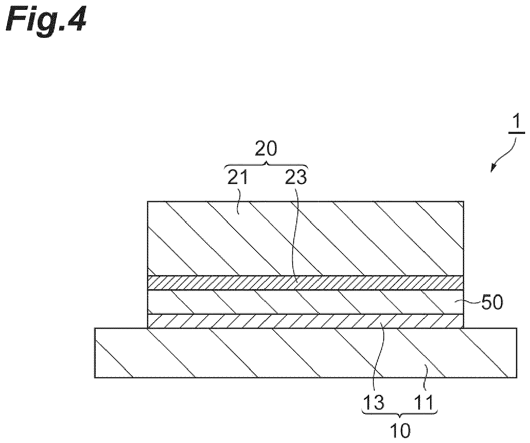

FIG. 4 is a cross-sectional view illustrating an embodiment of a power semiconductor device obtained by the above method. A power semiconductor device 1 illustrated in FIG. 4 includes the power semiconductor element 20 having the electrode 23, the wiring substrate 10 having the wiring layer 13, and a sintered metal layer 50 formed from a sintering material. The electrode 23 of the power semiconductor element 20 and the wiring layer 13 of the wiring substrate 10 are electrically connected through the sintered metal layer 50. Since the power semiconductor element 20 is electrically connected to the wiring substrate 10 by the dense sintered metal layer 50 with less pores, the power semiconductor device 1 has excellent thermal conductivity and connection reliability.

The number of the power semiconductor elements mounted on one wiring substrate is not particularly limited. The number of the power semiconductor elements mounted on one wiring substrate may be two or more or three or more from the viewpoint of production efficiency, or may be six or more from the request of the configuration of the power semiconductor device. In the case of mounting a plurality of power semiconductor elements on one wiring substrate, a laminate having one wiring substrate and a plurality of power semiconductor elements may be heated and pressured one by one or a plurality of the laminates may be collectively heated and pressured. The advantageous effect obtained by the method of the present embodiment becomes more remarkable as the number of power semiconductor elements collectively mounted increases. The upper limit of the number of the power semiconductor elements mounted on one wiring substrate is not particularly limited, but may be, for example, 50 or less.

The porosity of the sintered metal layer formed by sintering the sintering material tends to increase to reduce connection reliability when a pressure applied during sintering is insufficient. In the case of collectively heating and pressuring a plurality of laminates, unevenness of pressure may occur to some extent due to a factor such as a variation in thickness of the sintering material and the wiring substrate, warpage of the wiring substrate in a high temperature, or distortion and inclination of the press-bonding head. It is considered that the unevenness of pressure increases the porosity of the sintered metal layer connecting the power semiconductor elements, that is, the sintered metal layer becomes sparse. By alleviating the unevenness of pressure applied to the sintering material by the sheet for hot pressing having a thermosetting resin layer, a dense sintered metal layer having a low porosity is stably formed. As a result, it is considered that a plurality of power semiconductor elements can be collectively mounted on a wiring substrate with high connection reliability. Even in a case where an electrode of a power semiconductor element and a wiring layer of a wiring substrate are electrically connected by heating and pressuring only one laminate having one power semiconductor element on one wiring substrate, the unevenness of pressure may occur in the plane of the one laminate. Therefore, the method using the sheet for hot pressing can contribute to improvement in connection reliability.

Wiring substrate

The wiring substrate 10 has the insulating substrate 11 and the wiring layer 13 provided on the insulating substrate 11. The type of the insulating substrate 11 is not particularly limited. For example, the insulating substrate 11 can be selected from an organic substrate containing a fiber base material such as FR4 or FR5; a build-up organic substrate not containing a fiber base material; an organic resin film such as polyimide or polyester; and a substrate containing an inorganic material such as ceramic, alumina, glass, or silicon. In particular, the insulating substrate 11 may be a ceramic substrate that is excellent in terms of heat resistance and impact resistance required for a power semiconductor device.

The wiring layer 13 is typically a conductor wiring including an electrode for connection. The wiring layer 13 is formed, for example, by a method such as a semi-additive method or a subtractive method. Depending on the type of the sintering material, the wiring layer 13 may be plated with a metal such as silver, gold, or nickel.

Sintering material

The sintering material 50A contains metal particles and is generally in the form of a paste. The particle size of the metal particles may be, for example, 100 nm or less. As the sintering material, for example, a copper paste containing copper particles or a silver paste containing silver particles can be used. The sintered metal layer 50 formed from the silver paste includes a sintered body (silver bulk) formed by aggregating the silver particles. The sintered metal layer containing the silver bulk is difficult to remelt during secondary mounting, and thus is particularly excellent in terms of stable connection.

By coating the sintering material 50A on the wiring layer 13, the sintering material 50A can be supplied onto the wiring layer 13. Examples of the method of coating the sintering material include a method using a metal mask or a mesh-shaped mask having an opening formed in a coated portion, a method of coating a sintering material on a necessary portion using a dispenser, and a method of forming a pattern having an opening formed in a coated portion by a water-repellent resin and coating a sintering material on the opening portion thereof. The water-repellent resin is, for example, a resin containing silicone or fluorine. The pattern of the water-repellent resin can be formed, for example, by a method of coating a water-repellent resin using a metal mask or a mesh-shaped mask having an opening formed in a necessary portion, a method of exposing and developing a photosensitive water-repellent resin, or a method of removing a part of a water-repellent resin coated on a wiring substrate by a laser. These coating methods can be combined according to the area and shape of the electrodes to be joined.

Heating and pressuring of laminate

The number of laminates disposed on the stage when the laminate is heated and pressured is not particularly limited. From the viewpoint of production efficiency, the number of laminates disposed on the stage may be two or more, three or more, or five or more. The effect of the manufacturing method of the present embodiment is more remarkable as the number of laminates to be collectively heated and pressured is larger. The upper limit of the number of laminates disposed on the stage is not particularly limited, but may be, for example, 100 or less.

The conditions for heating and pressuring the laminate are not particularly limited as long as a sintered metal layer having a small porosity is formed from a sintering material.

The heating temperature of the laminate is not particularly limited, but for example, may be 150°C or higher or 250°C or higher or may be 380°C or lower or 250°C or lower. By setting such a heating temperature, the sintering material can be efficiently sintered. This heating temperature is usually the temperature of the stage or the press-bonding head.

The pressure for pressuring the laminate is not particularly limited, but for example, may be 10 MPa or more or 2 MPa or more or may be 50 MPa or less or 10 MPa or less. By pressuring the laminate at such a pressure, there is a tendency that a sintered metal layer with less pores can be efficiently formed.

The atmosphere when the laminate is heated and pressured is not particularly limited, but may be a reducing atmosphere containing hydrogen or formic acid or a non-oxidizing atmosphere of nitrogen or the like.

Sheet for hot pressing

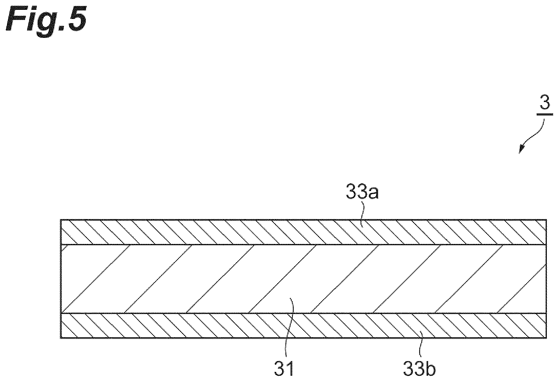

FIG. 5 is a cross-sectional view illustrating a sheet for hot pressing according to an embodiment. The sheet for hot pressing 3 illustrated in FIG. 5 has a thermosetting resin layer 31 and release sheets 33a and 33b provided on both sides of the thermosetting resin layer 31. The thermosetting resin layer 31 is formed by molding a thermosetting resin composition containing a thermosetting resin into a sheet. The thermosetting resin layer 31 or the thermosetting resin composition for forming the same may contain a polymerization initiator, a curing agent for curing the thermosetting resin, or both thereof. The thermosetting resin composition may further contain other components as necessary. A release sheet may be provided on one side of the thermosetting resin layer 31.

The thickness of the thermosetting resin layer 31 may be, for example, 20 $\mu$m or more or 40 $\mu$m or more from the viewpoint of a thickness that can follow power semiconductor elements having different heights. The thickness of the thermosetting resin layer 31 may be, for example, 300 $\mu$m or less or 200 $\mu$m or less from the viewpoint of film formability. The thickness of the sheet for hot pressing 3 including the release sheets 33a and 33b may be, for example, 50 $\mu$m to 400 $\mu$m.

Thermosetting resin

The thermosetting resin is a compound having a reactive functional group that forms a crosslinked structure and cures a thermosetting resin layer. Examples of the thermosetting resin include a (meth)acrylate compound, an epoxy compound, a bismaleimide compound, a cyanate compound, and a phenol compound. From the viewpoints of the viscosity of the thermosetting resin layer and the thermal expansion rate of the cured product of the thermosetting resin composition, the thermosetting resin may include at least one selected from the group consisting of a (meth)acrylate compound, an epoxy compound, a bismaleimide compound, and a phenol compound, or may include at least one selected from the group consisting of a (meth)acrylate compound, an epoxy compound, and a bismaleimide compound. From the viewpoint of a curing rate, the thermosetting resin may include at least one selected from the group consisting of a (meth)acrylate compound and an epoxy compound. These thermosetting resins may be used alone or in combination of two or more kinds thereof.

The content of the thermosetting resin in the thermosetting resin composition is not particularly limited. From the viewpoint of obtaining sufficient curability, the content of the thermosetting resin may be, for example, 5% by mass or more or 10% by mass or more on the basis of the mass of the thermosetting resin composition. From the viewpoint of the fluidity of the thermosetting resin composition, the content of the thermosetting resin may be, for example, 70% by mass or less or 60% by mass or less on the basis of the mass of the thermosetting resin composition.

In the present specification, the content of each component determined on the basis of the mass or volume of the thermosetting resin composition is a value calculated on the basis of the mass of solid content or the total mass of components other than the solvent contained in the thermosetting resin composition even in a case where the thermosetting resin composition contains the solvent.

Herein, the solid content of the thermosetting resin composition refers to components other than volatile components such as moisture and a solvent described later. The solid content includes a liquid type or a waxy type at a temperature near 25°C, and is not necessarily solid. In the present specification, volatile components (that is, moisture and a solvent) mean substances having a boiling point of 200°C or lower under atmospheric pressure.

The thermosetting resin layer 31 and the thermosetting resin composition for forming the same may contain a (meth)acrylate compound as the thermosetting resin. The (meth)acrylate compound has an acrylate group, a methacrylate group, or both thereof. The (meth)acrylate compound is not particularly limited and can be appropriately selected from (meth)acrylate compounds which are generally used. The (meth)acrylate compound can be a monofunctional (meth)acrylate having one (meth)acrylate group, a polyfunctional (meth)acrylate compound having two or more (meth)acrylate groups, or a combination thereof. The "(meth)acrylate group" means a methacrylate group or an acrylate group.

Examples of the (meth)acrylate compound include erythritol poly(meth)acrylate, a (meth)acrylate compound having a glycidyl ether group, a di(meth)acrylate compound having a diol unit derived from bisphenol A, a di(meth)acrylate compound having a cyclodecane group, methylol (meth)acrylate, glycol di(meth)acrylate, a di(meth)acrylate compound having a dioxane group, a (meth)acrylate compound having a diol unit derived from bisphenol F, dimethylol (meth)acrylate, isocyanurate di(meth)acrylate, and trimethylol tri(meth)acrylate. The (meth)acrylate compound may include at least one selected from the group consisting of trimethylol tri(meth)acrylate, an isocyanurate di(meth)acrylate compound, a (meth)acrylate compound having a diol unit derived from bisphenol F, a di(meth)acrylate compound having a cyclodecane group, and a (meth)acrylate compound having a glycidyl ether group. These (meth)acrylate compounds may be used alone or in combination of two or more kinds thereof.

The content of the (meth)acrylate compound in the thermosetting resin layer and the thermosetting resin composition for forming the same is not particularly limited, but from the viewpoint of obtaining sufficient curability, the content thereof may be, for example, 5% by mass or more or 10% by mass or more with respect to the mass of the thermosetting resin layer or the mass of solid content of the thermosetting resin composition. The content of the (meth)acrylate compound may be, for example, 70% by mass or less or 60% by mass or less with respect to the mass of the thermosetting resin layer or the mass of solid content of the thermosetting resin composition, from the viewpoint of the fluidity of the thermosetting resin layer.

The curing start temperature of the thermosetting resin may be lower than the sintering temperature of the sintering material. When the curing start temperature of the thermosetting resin is lower than the sintering temperature of the sintering material, unevenness of pressure applied to the power semiconductor element and the wiring substrate when the laminate is heated and pressured tends to be easily suppressed.

Before the sheet for hot pressing is used in hot pressing by the stage and the press-bonding head, the curing reaction of the thermosetting resin (for example, the (meth)acrylate compound) contained in the thermosetting resin layer may proceed to some extent. As a result, even in a case where a variation in thickness or the like of the power semiconductor element becomes large, a more remarkable effect can be obtained in terms of eliminating the load non-uniformity. For example, by adjusting drying conditions for forming the thermosetting resin layer or performing a thermal treatment or ultraviolet irradiation, the curing reaction of the thermosetting resin layer can be advanced to some extent.

The degree of the progress of the curing reaction of the thermosetting resin layer can be estimated on the basis of the melt viscosity of the thermosetting resin layer. Specifically, the minimum melt viscosity of the thermosetting resin layer in a range of 25°C to 180°C may be 1000 to 100000 Pa·s. When the minimum melt viscosity is 1000 or more, in the sheet for hot pressing which is deformed for eliminating the load non-uniformity, the thermosetting resin layer is easy to maintain the shape without excessively flowing. When the minimum melt viscosity is 100000 or less, the sheet for hot pressing tends to be easily deformed so as to eliminate the load non-uniformity. From the same viewpoint, the minimum melt viscosity of the thermosetting resin layer in a range of 25°C to 180°C may be 5000 to 50000 Pa·s or 10000 to 30000 Pa·s. The minimum melt viscosity of the thermosetting resin layer is the minimum value of viscosity (complex viscosity rate) when the viscosity (complex viscosity rate) of the thermosetting resin layer is measured under the conditions of a 5% oscillation angle, a frequency of 1 Hz, and a temperature increasing rate of 10°C/min. The viscosity (complex viscosity rate) can be measured, for example, using a rheometer (dynamic viscoelastic measuring device, device name: MCR301, manufactured by Anton Paar GmbH).

Polymerization initiator (radical polymerization initiator)

In a case where the thermosetting resin layer and the thermosetting resin composition for forming the same contains a (meth)acrylate compound as the thermosetting resin, in order to accelerate the polymerization reaction of the (meth)acrylate compound, the thermosetting resin layer and the thermosetting resin composition may contain a radical polymerization initiator. The radical polymerization initiator is typically a thermal radical polymerization initiator, but may be a photoradical polymerization initiator. The radical polymerization initiator may be a combination of a thermal radical polymerization initiator and a photoradical polymerization initiator.

Examples of the thermal radical polymerization initiator include ketone peroxide, hydroperoxide, diacyl peroxide, dialkyl peroxide, peroxyketal, alkyl perester (peroxyester), and peroxycarbonate. These radical polymerization initiators may be used alone or in combination of two or more kinds thereof.

Specific examples of ketone peroxide include methyl ethyl ketone peroxide, methyl isobutyl ketone peroxide, acetylacetone peroxide, cyclohexanone peroxide, and methylcyclohexanone peroxide.

Specific examples of the hydroperoxide include 1,1,3,3-tetramethylbutyl hydroperoxide, cumene hydroperoxide, t-butyl hydroperoxide, p-menthane hydroperoxide, and diisopropylbenzene hydroperoxide.

Specific examples of the diacyl peroxide include diisobutyryl peroxide, bis-3,5,5-trimethylhexanol peroxide, dilauroyl peroxide, dibenzoyl peroxide, m-toluyl benzoyl peroxide, and succinic acid peroxide.

Specific examples of the dialkyl peroxide include dicumyl peroxide, 2,5-dimethyl-2,5-bis(t-butylperoxy)hexane, 1,3-bis(t-butylperoxyisopropyl)hexane, t-butylcumyl peroxide, di-t-butyl peroxide, di-t-hexyl peroxide, and 2,5 -dimethyl-2,5-bis(t-butylperoxy)hexine-3.

Specific examples of the peroxyketal include 1,1-bis(t-hexylperoxy)-3,3,5-trimethylcyclohexane, 1,1-bis(t-hexylperoxy)cyclohexane, 1,1-bis(t-butylperoxy)-2-methylcyclohexane, 1,1-bis(t-butylperoxy)cyclohexane, 2,2-bis(t-butylperoxy)butane, and 4,4-bis(t-butylperoxy)butyl pentanoate.

Specific examples of the alkyl perester (peroxyester) include 1,1,3,3-tetramethylbutyl peroxyneodecanoate, $\alpha$-cumyl peroxyneodecanoate, t-butyl peroxyneodecanoate, t-hexyl peroxyneodecanoate, t-butyl peroxyneoheptanoate, t-hexyl peroxypivalate, t-butyl peroxypivalate, 1,1,3,3-tetramethylbutyl peroxy-2-ethylhexanoate, t-amylperoxy-2-ethylhexanoate, t-butylperoxy-2-ethylhexanoate, t-butyl peroxyisobutyrate, di-t-butyl peroxyhexahydroterephthalate, 1,1,3,3-tetramethylbutyl peroxy-3,5,5-trimethylhexanoate, t-amylperoxy3,5,5-trimethylhexanoate, t-butylperoxy-3,5,5-trimethylhexanoate, t-butyl peroxyacetate, t-butyl peroxybenzoate, dibutyl peroxytrimethyladipate, 2,5-dimethyl-2,5-di-2-ethylhexanoyl peroxyhexane, t-hexylperoxy-2-ethylhexanoate, t-hexyl peroxyisopropyl monocarbonate, t-butyl peroxylaurate, t-butyl peroxyisopropyl monocarbonate, t-butylperoxy-2-ethylhexyl monocarbonate, and 2,5-dimethyl-2,5-di-benzoylperoxyhexane.

Specific examples of the peroxycarbonate include di-n-propyl peroxydicarbonate, diisopropyl peroxycarbonate, di-4-t-butylcyclohexyl peroxycarbonate, di-2-ethylhexyl peroxycarbonate, di-sec-butyl peroxycarbonate, di-3-methoxybutyl peroxydicarbonate, di-2-ethylhexyl peroxydicarbonate, diisopropyloxy dicarbonate, t-amyl peroxyisopropyl carbonate, t-butyl peroxyisopropyl carbonate, t-butylperoxy-2-ethylhexyl carbonate, and 1,6-bis(t-butyl peroxycarboxy)hexane.

From the viewpoint of curability, the thermal radical polymerization initiator may contain a cyclohexane type peroxide such as 1,1 -bis(t-butylperoxy)cyclohexane.

The photoradical polymerization initiator may be a compound having an alkylphenone structure. Examples of commercially available products thereof include IRGACURE 651, IRGACURE 184, IRGACURE 1173, IRGACURE 2959, IRGACURE 127, IRGACURE 907, IRGACURE 369, and IRGACURE 379EG. IRGACURE OXE01 and IRGACURE OXE02 that are compounds having an oxime ester in the molecule (all manufactured by BASF, trade name ("IRGACURE" is registered trademark)), N-1919 (manufactured by ADEKA Corporation), and IRGACURE 819 and LUCIRIN TPO containing a phosphorus element (all manufactured by BASF, trade name ("LUCIRIN" is registered trademark)) can also be used. The photoradical polymerization initiator can be used alone or in combination of two or more kinds thereof. The photoradical polymerization initiator may be used in combination with a sensitizer.

The content of the radical polymerization initiator may be 0.01 to 10 parts by mass or 0.1 to 5 parts by mass with respect to 100 parts by mass of the thermosetting resin layer or the thermosetting resin composition.

The content of the radical polymerization initiator in the thermosetting resin layer and the thermosetting resin composition for forming the same may be 0.0 to 10 parts by mass or 0.1 to 5 parts by mass with respect to 100 parts by mass of the content of the (meth)acrylate compound.

Polymerization inhibitor

In a case where the thermosetting resin layer and the thermosetting resin composition for forming the same contain a (meth)acrylate compound as the thermosetting resin, the thermosetting resin layer and the thermosetting resin composition may further contain a polymerization inhibitor. The thermosetting resin layer and the thermosetting resin composition may contain a (meth)acrylate compound, a radical polymerization initiator, and a polymerization inhibitor.

The (meth)acrylate compound may be radically polymerized under the influence of heat, oxygen, or the like during storage, regardless of the presence or absence of the radical polymerization initiator described later, which may affect the stability of power semiconductor device manufacturing. By combining a polymerization inhibitor with the (meth)acrylate compound, it is considered that the stability of power semiconductor device manufacturing is improved. The polymerization inhibitor is not particularly limited as long as it has a polymerization inhibiting effect on radical polymerization. The polymerization inhibitor may be, for example, a phenolic, phosphorus-based, or thioether-based polymerization inhibitor, or a combination thereof.

Examples of the phenolic polymerization inhibitor include petitaerythrityl-tetrakis[3-(3,5-di-t-butyl-4-hydroxyphenyl)propionate], 3,9-bis{2-[3-(3-t-butyl-4-hydroxy-5-methylphenyl)propionyloxy]-1,1-di methylethyl}2,4,8,10-tetraoxaspiro[5,5]undecane, octadecyl-3-(3,5-di-t-butyl-4-hydroxyphenyl)propionate, 1,6-hexanediol-bis[3-(3,5-di-t-butyl-4-hydroxyphenyl)propionate], 1,3,5-trimethyl-2,4,6-tris(3,5-di-t-butyl-4-hydroxybenzyl)benzene, 2,6-di-t-butyl-4-methylphenol, 2,6-di-t-butyl-4-ethylphenol, 2,6-diphenyl-4-octadecyloxyphenol, stearyl (3,5-di-t-butyl-4-hydroxyphenyl)propionate, distearyl (3,5-di-t-butyl-4-hydroxybenzyl)phosphonate, thiodiethylene glycol bis[(3,5-di-t-butyl-4-hydroxyphenyl)propionate], 4,4'-thiobis(6-t-butyl-m-cresol), 2-octylthio-4,6-di(3,5-di-t-butyl-4-hydroxyphenoxy)-s-triazine, 2,2'-methylenebis(4-methyl-6-t-butyl-6-butylphenol), 2,-2'-methylenebis(4-ethyl-6-t-butylphenol), bis[3,3-bis(4-hydroxy-3-t-butylphenyl)butyric acid] glycol ester, 4,4'-butylidenebis(6-t-butyl-m-cresol), 2,2'-ethylidenebis(4,6-di-t-butylphenol), 2,2'-ethylidenebis(4-s-butyl-6-t-butylphenol), 1,1,3-tris(2-methyl-4-hydroxy-5-t-butylphenyl)butane, bis[2-t-butyl-4-methyl-6-(2-hydroxy-3-t-butyl-5-methylbenzyl)phenyl] terephthalate, 1.3.5-tris(2,6-dimethyl-3-hydroxy-4-t-butylbenzyl) isocyanurate, 1,3,5-tris(3,5-di-t-butyl-4-hydroxybenzyl)-2,4,6-trimethylbenzene, 1,3,5-tris[(3,5-di-t-butyl-4-hydroxyphenyl)propionyloxyethyl] isocyanurate, tetrakis[methylene-3-(3,5-di-t-butyl-4-hydroxyphenyl)propionate]metha ne, 2-t-butyl-4-methyl-6-(2-acryloyloxy-3-t-butyl-5-methylbenzyl)phenol, 3,9-bis(1,1-dimethyl-2-hydroxyethyl)-2,4-8,10-tetraoxaspiro[5 ,5]undecane-bis[β-(3-t-butyl-4-hydroxy-5-methylphenyl)propionate], triethylene glycol bis[β-(3-t-butyl-4-hydroxy-5-methylphenyl)propionate], 1,1'-bis(4-hydroxyphenyl)cyclohexane, 2,2'-methylenebis(4-methyl-6-t-butylphenol), 2,2'-methylenebis(4-ethyl-6-t-butylphenol), 2,2'-methylenebis(6-(1-methylcyclohexyl)-4-methylphenol), 4,4'-butylidenebis(3-methyl-6-t-butylphenol), 3,9-bis(2-(3-t-butyl-4-hydroxy-5-methylphenylpropionyloxy)1,1-dimeth ylethyl)-2,4,8,10-tetraoxaspiro(5,5)undecane, 4,4'-thiobis(3-methyl-6-t-butylphenol), 4,4'-bis(3,5-di-t-butyl-4-hydroxybenzyl)sulfide, 4,4'-thiobis(6-t-butyl-2-methylphenol), 2,5-di-t-butylhydroquinone, 2,5 -di-t-amylhydroquinone, 2-t-butyl-6-(3-t-butyl-2-hydroxy-5-methylbenzyl)-4-methylphenylacryla te, 2,4-dimethyl-6-(1-methylcyclohexyl, styrenated phenol, and 2,4-bis((octylthio)methyl)-5-methylphenol. The phenolic polymerization inhibitor may be a hindered phenolic polymerization inhibitor.

Examples of the phosphorus-based polymerization inhibitor include bis-(2,6-di-t-butyl-4-methylphenyl)pentapentaerythritol diphosphite, tris(2,4-di-t-butylphenyl phosphite), tetrakis(2,4-di-t-butyl-5-methylphenyl)-4,4'-biphenylene diphosphonite, 3,5-di-t-butyl-4-hydroxybenzyl phosphonate-diethyl ester, bis-(2,6-dicumylphenyl)pentaerythritol diphosphite, 2,2-methylenebis(4,6-di-t-butylphenyl)octylphosphite, tris(mono- or di-nonylphenyl phosphite), bis(2,4-di-t-butylphenyl)pentapentaerythritol-di, -phosphite, bis(2,6-di-t-butyl-4-methoxycarbonylethyl-phenyl)pentaerythritol diphosphite, and bis(2,6-di-t-butyl-4-octadecyloxycarbonylethyl-phenyl)pentaerythritol diphosphite.

Examples of the thioether-based polymerization inhibitor include dilauryl 3,3'-thiodipropionate, bis(2-methyl-4-(3-n-dodecyl)thiopropionyloxy)-5-t-butylphenyl) sulfide, distearyl-3,3'-thiodipropionate, and pentaerythritol-tetrakis(3-lauryl)thiopropionate.

One of polymerization inhibitors selected from the polymerization inhibitors exemplified above or a combination of two or more kinds thereof can be used.

The content of the polymerization inhibitor in the thermosetting resin layer and the thermosetting resin composition for forming the same may be 0.01 to 10 parts by mass or 0.1 to 5 parts by mass with respect to 100 parts by mass of the content of the (meth)acrylate compound. The content of the polymerization inhibitor may be 0.01 part by mass or more or 0.1 part by mass or more or may be 10 parts by mass or less or 5 parts by mass or less with respect to 100 parts by mass of the content of the (meth)acrylate compound. When the content of the polymerization inhibitor is in the above range, sufficient storage stability of the sheet for hot pressing is easily obtained while securing the polymerization reaction rate.

Epoxy compound

The thermosetting resin layer and the thermosetting resin composition for forming the same may contain an epoxy compound as the thermosetting resin. The epoxy compound is a compound having two or more epoxy groups in one molecule. For example, an epoxy compound that is generally used for manufacturing electronic components can be used. Examples of the epoxy compound include a bisphenol-type epoxy resin that is diglycidyl ether of a bisphenol compound, a novolak-type epoxy resin, a glycidyl ester-type epoxy resin, a glycidyl amine-type epoxy resin, a linear aliphatic epoxy resin, and an alicyclic epoxy resin. These epoxy resins may be used alone or in combination of two or more kinds thereof. From the viewpoints of reactivity and heat resistance, the epoxy compound may include a bisphenol-type epoxy resin, a glycidyl amine-type epoxy resin, or a combination thereof.

Examples of the bisphenol compounds that induce the bisphenol-type epoxy resin include bisphenol A, bisphenol F, bisphenol AD, bisphenol S, naphthalenediol, and hydrogenated bisphenol A. The bisphenol-type epoxy resin may be a compound obtained by reaction of these bisphenol compounds and epichlorohydrin.

The novolak-type epoxy resin may be a glycidyl ether of a novolak resin. The novolak resin is obtained, for example, by condensing or copolymerizing a phenol compound and an aldehyde compound. The novolak-type epoxy resin may be an orthocresol novolak-type epoxy resin.

The glycidyl ester-type epoxy resin is a glycidyl ester of a polybasic acid such as phthalic acid and dimer acid. The glycidyl ester-type epoxy resin is obtained, for example, by reaction of a polybasic acid and epichlorohydrin.

The glycidyl amine-type epoxy resin is a compound having a glycidyl group bonded to an amino group of an amine compound such as p-aminophenol, diaminodiphenylmethane, or isocyanuric acid. The glycidyl amine-type epoxy resin is obtained, for example, by reaction of an amine compound and epichlorohydrin.

The linear aliphatic epoxy resin may be a compound having an epoxy group formed by oxidation of an olefin bond of a linear or branched olefin compound. The olefin bond can be oxidized with a peracid such as peracetic acid.

The epoxy compound may be solid or liquid at 25°C. A solid epoxy compound and a liquid epoxy compound may be used in combination. From the viewpoint of reducing the viscosity of the thermosetting resin composition, the epoxy compound may be a liquid epoxy compound.

Curing agent

In a case where the thermosetting resin layer and the thermosetting resin composition for forming the same contain an epoxy compound as the thermosetting resin, the thermosetting resin layer and the thermosetting resin composition may contain a curing agent that cures the epoxy compound. The curing agent is not particularly limited, and can be selected from curing agents generally used. The curing agent may be solid or liquid at 25°C. A solid curing agent and a liquid curing agent may be used in combination. From the viewpoint of curing in a short time, the curing agent may contain at least one acid anhydride.

The equivalent ratio between the epoxy compound and the curing agent (functional group equivalent reacting with an epoxy group) is not particularly limited. From the viewpoint of reducing unreacted components of the respective components, for example, the equivalent ratio of the curing agent to the epoxy compound may be 0.1 equivalent to 2.0 equivalents, 0.5 equivalent to 1.25 equivalents, or 0.8 equivalent to 1.2 equivalents.

Curing accelerator

In a case where the thermosetting resin layer and the thermosetting resin composition for forming the same contain an epoxy compound as the thermosetting resin, the thermosetting resin layer and the thermosetting resin composition may further contain a curing accelerator accelerating the curing reaction between the epoxy compound and the curing agent. Examples of the curing accelerator include a phosphorus-based curing accelerator, an amine-based curing accelerator, an imidazole-based curing accelerator, and a guanidine-based curing accelerator. The curing accelerator may be at least one selected from a phosphorus-based curing accelerator, an amine-based curing accelerator, and an imidazole-based curing accelerator. The curing accelerator may be used alone or in combination of two or more kinds thereof.

The content of the curing accelerator may be 0.05 to 3% by mass when the total solid content (or components other than the solvent) of the epoxy compound and the curing agent is 100% by mass.

Thermoplastic resin

The thermosetting resin layer and the thermosetting resin composition for forming the same may contain a thermoplastic resin. Examples of the thermoplastic resin include an acrylic resin, a styrene resin, a butadiene resin, an imide resin, and an amide resin. These thermoplastic resins may be used alone or in combination of two or more kinds thereof.

The thermoplastic resin can be, for example, a polymer produced by radical polymerization of a polymerizable monomer. This thermosetting resin contains a monomer unit derived from a polymerizable monomer. Examples of the polymerizable monomer include (meth)acrylic acid; (meth)acrylic acid esters such as methyl (meth)acrylate, ethyl (meth)acrylate, and benzyl (meth)acrylate; (meth)acrylamides such as diacetone (meth)acrylamide; styrene or styrene derivatives such as styrene, vinyl toluene, and α-methylstyrene; ethers of vinyl alcohols such as vinyl-n-butyl ether; maleic acid; maleic acid monoesters such as monomethyl maleate and monoethyl maleate; fumaric acid; cinnamic acid; itaconic acid; and crotonic acid. These polymerizable monomers may be used alone or in combination of two or more kinds thereof. The thermoplastic resin may be an acrylic block copolymer formed by block copolymerization of at least one compound exemplified as the (meth)acrylate compound.

As the thermoplastic resin, commercially available products may be used. Examples thereof include "LA series of KURARITY (LA-2140, LA-2250, LA-2330, and LA-4285" manufactured by Kuraray Co., Ltd.

In the present specification, "(meth)acrylic acid" means acrylic acid or methacrylic acid, and "(meth)acrylamide" means acrylamide or methacrylamide.

The weight average molecular weight of the thermoplastic resin may be, for example, 5000 to 1000000 or 20000 to 500000 from the viewpoints of film formability and fluidity.

The weight average molecular weight in the present specification means a value measured by a gel permeation chromatography (GPC) method and converted by a calibration curve prepared using standard polystyrene. GPC conditions are shown below.

Pump: L-6000 type (manufacture by Hitachi, Ltd., trade name)

Column: Gelpack GL-R420 + Gelpack GL-R430 + Gelpack GL-R440 (three in total) (manufactured by Hitachi Chemical Company, Ltd., trade name)

Eluent: Tetrahydrofuran (THF)

Measurement temperature: 40°C

Flow rate: 2.05 mL/min

Detector: L-3300 type RI (manufactured by Hitachi, Ltd., trade name)

In a case where the thermosetting resin composition contains a thermoplastic resin, the content of the thermoplastic resin may be, for example, 1 to 70% by mass or 5 to 50% by mass with respect to the mass of the thermosetting resin composition. When the content of the thermoplastic resin is 1% by mass or more, the film formability of the thermosetting resin composition tends to be improved. When the content of the thermoplastic resin is 70% by mass or less, the curability tends to be improved and the bonding property between the power semiconductor element and the wiring substrate tends to be improved.

Inorganic filler

The thermosetting resin layer and the thermosetting resin composition for forming the same may contain at least one inorganic filler. The inorganic filler may contain, for example, particles or spherical particles containing an inorganic material selected from silica (such as molten silica or crystalline silica), calcium carbonate, clay, alumina (such as alumina oxide), silicon nitride, silicon carbide, boron nitride, calcium silicate, potassium titanate, aluminum nitride, beryllia, zirconia, zircon, forsterite, steatite, spinel, mullite, titania, and the like. The inorganic filler may contain glass fibers. These inorganic fillers may be used alone or in combination of two or more kinds thereof.

The volume average particle size of the inorganic filler may be, for example, 0.01 to 15.0 μm or 0.3 to 5.0 μm. When the volume average particle size is 0.01 μm or more, the viscosity of the thermosetting resin composition can be easily adjusted on the basis of the amount of the inorganic filler added. When the volume average particle size is 15.0 μm or less, there is a tendency that the curability can be adjusted and the elastic modulus of a cured product can be controlled without impairing the following property to irregularities of the sheet for hot pressing.

In the present specification, the "volume average particle size" means a particle size (D50) at which 50% of the particles are accumulated from the smaller size side in a volume integrated distribution curve obtained using a laser diffraction particle size distribution measurement device.

In a case where the thermosetting resin layer and the thermosetting resin composition for forming the same contain an inorganic filler, the content of the inorganic filler may be, for example, 5 to 90% by mass, 20 to 85% by mass, or 60 to 85% by mass on the basis of the mass of the thermosetting resin layer or the thermosetting resin composition for forming the same. When the content of the inorganic filler is 30% by mass or more, the effect of reducing a thermal expansion coefficient tends to increase, and humidity resistance reliability tends to be improved. When the content of the inorganic filler is 80% by mass or less, there is a tendency that the addition of the inorganic filler can suppress the effects of the moldability of the thermosetting resin layer, powder fall, and the like.

The content of the inorganic filler may be 1 to 80% by volume or 30 to 70% by volume on the basis of the volume of the thermosetting resin layer or the thermosetting resin composition for forming the same. The content percentage based on volume of the inorganic filler in the thermosetting resin composition is measured by a method including the following (i), (ii), (iii), and (iv).

(i) The mass (Wc) of the thermosetting resin composition at 25°C is measured. This thermosetting resin composition is subjected to a thermal treatment in air at 400°C for 2 hours and then at 700°C for 3 hours and the resin component is burned and removed. The mass (Wf) of the remaining inorganic filler at 25°C is measured.

(ii) The specific gravity (df) of the inorganic filler at 25°C is obtained using an electronic hydrometer or a pycnometer.

(iii) The specific gravity (dc) of the thermosetting resin composition at 25°C is measured using an electronic hydrometer or a pycnometer.

(iv) The volume (Vc) of the thermosetting resin composition and the volume (Vf) of the remaining inorganic filler are obtained by (Equation 1). From these, the volume ratio (Vr) of the inorganic filler is obtained.

$$(\text{Equation 1})$$

$$Vc = Wc/dc$$

$$Vf = Wf/df$$

$$Vr = Vf/Vc$$

Vc: Volume ($cm^3$) of thermosetting resin composition, Wc: Mass (g) of thermosetting resin composition
dc: Density (g/$cm^3$) of thermosetting resin composition
Vf: Volume ($cm^3$) of inorganic filler, Wf: Mass (g) of inorganic filler
df: Density (g/$cm^3$) of inorganic filler
Vr: Volume ratio of inorganic filler

Other components

The thermosetting resin layer and the thermosetting resin composition for forming the same may contain other components as necessary. Examples of the other components include a coupling agent, a colorant, a solvent, a surfactant, an ion trapping agent, and the like. The thermosetting resin layer and the thermosetting resin composition may contain a photo cation polymerization initiator or a photo anion polymerization initiator.

The thermosetting resin composition may contain at least one solvent. The thermosetting resin composition containing a solvent can be used as a varnish for forming a thermosetting resin layer. By using the varnish of the thermosetting resin composition, a thermosetting resin layer can be formed with favorable workability. Examples of the solvent include methyl ethyl ketone, xylene, toluene, acetone, ethylene glycol monoethyl ether, cyclohexanone, ethyl ethoxypropionate, N,N-dimethylformamide, and N,N-dimethylacetamide. These solvents may be used alone or in combination of two or more kinds thereof.

The content of the solvent in the thermosetting resin composition is not particularly limited. For example, the content thereof is adjusted according to equipment for producing a resin sheet.

The varnish of the thermosetting resin composition can be obtained, for example, by mixing a component of the thermosetting resin composition in the aforementioned solvent. The thermosetting resin layer may be formed by a method of coating a varnish on a release sheet and removing a solvent from a coating film or drying the coating film.

Release sheet

The release sheets 33a and 33b are sheets having such a release property that the sheets do not stick to the press-bonding head and the laminate after heating and pressuring the laminate. The release sheets 33a and 33b are provided for easy release. However, for example, in a case where the thermosetting resin layer 31 itself has a release property after being cured, the release sheets 33a and 33b may not be provided. Examples of the release sheets 33a and 33b include organic resin films such as a polyethylene film, a polyolefin film of polyvinyl chloride or the like, a polyethylene terephthalate film, a polyethylene naphthalate film, a polycarbonate film, and a polyimide film; exfoliate paper; and metal foils such as a copper foil and an aluminum foil. Release layer-attached organic resin films or release layer-attached metal foils can also be used. The release sheets 33a and 33b may be a polyimide film or metal foils such as a copper foil and an aluminum foil from the viewpoint of heat resistance.

Method for producing hot pressed sheet

The sheet for hot pressing 3 can be obtained, for example, by a method which includes coating a varnish of the thermosetting resin composition containing the thermosetting resin mentioned above on the release sheet 33a and drying the coated varnish of the thermosetting resin composition to form the thermosetting resin layer 31 and laminating the release sheet 33b on the thermosetting resin layer 31.

Coating of the varnish onto the release sheet 33a can be performed by an ordinary method. Specific examples thereof include methods such as comma coating, die coating, lip coating, and gravure coating.

Drying of the varnish coated on the release sheet 33a is not particularly limited as long as at least a part of the solvent contained in the varnish can be removed, and a drying method can be appropriately selected from drying methods generally used. Instead of the method using the varnish, a thermosetting resin composition whose fluidity is reduced by a photoreaction may be coated on the release sheet 33a and the coated thermosetting resin composition may be irradiated with ultraviolet light.

**Examples**

Hereinafter, the present invention will be described in more detail by means of Examples, but the present invention is not limited to these Examples.

Example 1-1

(1) Preparation of thermosetting resin composition

In a flask equipped with a stirrer, 196.6 g of acrylic block copolymer (manufactured by Kuraray Co., Ltd., trade name "LA4285") as the thermoplastic resin and 98.32 g of trimethylolpropane triacrylate (manufactured by Hitachi Chemical Company, Ltd., trade name "TMPT21") as the thermosetting resin were put. Next, 1.5 g of 1,1-bis(t-butylperoxy)cyclohexane (manufactured by NOF CORPORATION, trade name "PERHEXA C") as the polymerization initiator, 843.6 g of silica particles (manufactured by Admatechs Company Limited, trade name "SE2050," volume average particle size: 0.5 $\mu$m) as the inorganic filler, and 288.5 g of methyl ethyl ketone as the solvent were added and mixed under stirring, thereby obtaining a varnish of the thermosetting resin composition.

(2) Production of sheet for hot pressing

The obtained varnish of the thermosetting resin composition was coated on a polyimide film (manufactured by DU PONT-TORAY CO., LTD., trade name "Kapton 100H," average thickness: 25 $\mu$m) as the release sheet. The coated thermosetting resin composition was dried by heating for 10 minutes by a drier at 70°C to form a thermosetting resin layer having an average thickness of 40 $\mu$m on the polyimide film. The same polyimide film as described above was overlaid on the thermosetting resin layer and bonded using a hot roll laminator under the conditions of 100°C, 0.5 MPa, and 1.0 m/min. According to the above procedure, a sheet for hot pressing A having the polyimide film, the thermosetting resin layer, and the polyimide film, which were laminated in this order, was obtained.

(3) Production of sintering material

12 parts by mass of dipropylene glycol methyl ether acetate (manufactured by Daicel Corporation, abbreviated name "DPMA"), 12 parts by mass of isobornyl cyclohexanol (manufactured by Nippon Terpene Chemicals, Inc., abbreviated name "MTPH"), and 0.88 part by mass of stearic acid were kneaded for 10 minutes using a Raikai mixer to obtain a liquid component. 44 parts by mass of flake-form silver particles (manufactured by Fukuda Metal Foil & Powder Co., Ltd., trade name "AgC-239") and 44 parts by mass of spherical silver particles (manufactured by Metalor Technologies SA, trade name "K-0082P") were added to the obtained liquid component. The mixture was kneaded for 15 minutes using a Raikai mixer to obtain a silver paste.

(4) Semiconductor element-mounted substrate for connectivity evaluation

A metal mask was placed on a silver-plated copper plate. The silver paste was spread over the metal mask with a squeegee to thereby print the silver paste having a thickness of 100 $\mu$m at three places on one copper plate. The silver pastes at three places were respectively printed in a 3 mm $\times$ 3 mm square range. On each of the printed silver pastes at three places, a power semiconductor element having a 200 $\mu$m-thick silver plating as an electrode was placed one by one in such a direction that the electrode was in contact with the silver paste. In this way, a laminate in which three power semiconductor elements were disposed on one copper plate through the silver paste was obtained. The obtained laminate was disposed on the stage, and one sheet for hot pressing A was overlaid thereon to cover the three power semiconductor elements. Thereafter, the laminate was heated and pressured for 60 seconds at a load of 200 N by the press-bonding head, which was disposed to face the stage and was heated at 170°C, and the stage. Thereafter, after the press-bonding head was heated to 300°C, the laminate was heated and pressured for 150 seconds at a load of 2700 N by the press-bonding head and the stage. As a result, the silver paste was sintered to form a sintered metal layer, thereby obtaining a semiconductor element-mounted substrate for connectivity evaluation. In the obtained semiconductor element-mounted substrate, the copper plate and the electrodes of the three power semiconductor elements were electrically connected through the sintered metal layer.

Comparative Example 1-1

Electrodes of three power semiconductor elements were collectively connected electrically to a copper plate to obtain a semiconductor element-mounted substrate for connectivity evaluation in the same manner as in Example 1-1, except that a polyimide film (manufactured by DU PONT-TORAY CO., LTD., trade name "Kapton 100H," average thickness: 25 $\mu$m) was used instead of the sheet for hot pressing A.

Evaluation of connectivity

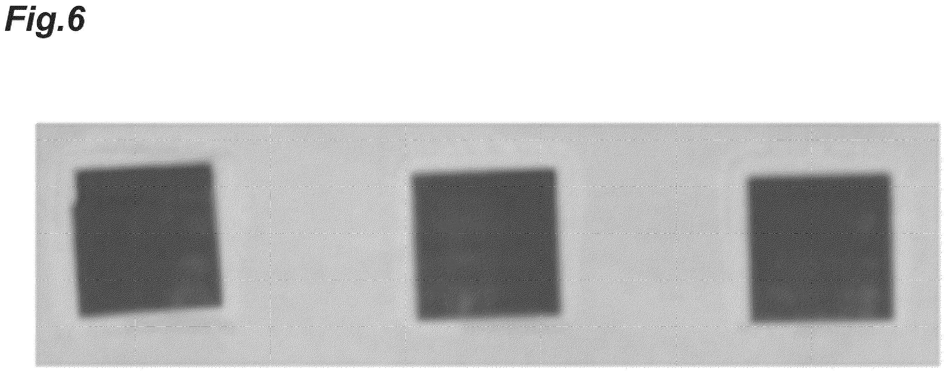

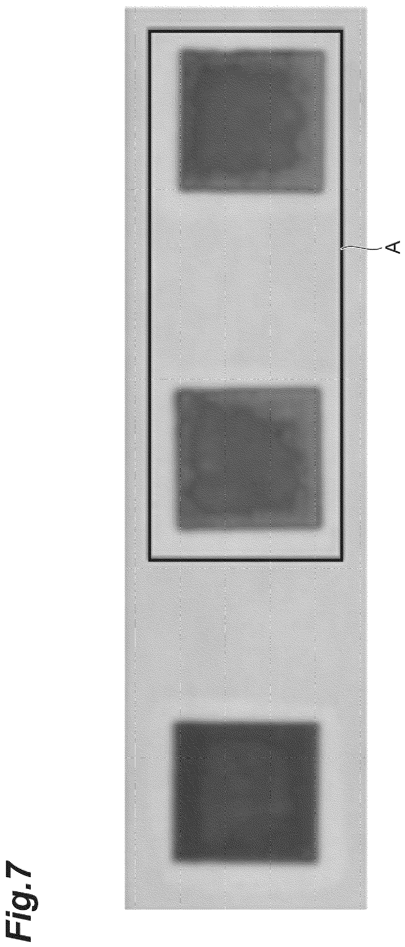

The inside of the semiconductor element-mounted substrate for connection evaluation was observed using an ultrasonic observation device (manufactured by Insight k.k., trade name, "INSIGHT-300"). The number (NG number) of three power semiconductor elements connected to the copper plate through the sintered metal layer that were observed to have peeling between the copper plate and the sintered metal layer, peeling of the inside of the sintered metal layer, peeling between the sintered metal layer and the power semiconductor element, or sparseness of the sintered metal layer was counted. The results are shown in Table 1. FIG. 6 is a cross-sectional image obtained by ultrasonic observation of a semiconductor element-mounted substrate of Example 1-1, and FIG. 7 is a cross-sectional image obtained by ultrasonic observation of a semiconductor element-mounted substrate of Comparative Example 1-1. As shown in FIG. 6, peeling was not observed in the semiconductor element-mounted substrate of Example 1-1; on the other hand, as shown in FIG. 7, peeling in the periphery of the connection portion of two power semiconductor elements in the frame A among three power semiconductor elements was observed in the semiconductor element-mounted substrate of Comparative Example 1-1.

Table 1

|  | Example 1-1 | Comparative Example 1-1 |
|---|---|---|
| Sheet for hot pressing | Sheet for hot pressing A (polyimide film/thermosetting resin layer/ polyimide film) | Polyimide film |
| Connectivity (NG number) | 0/3 | 2/3 |

Example 2-1

In a flask equipped with a stirrer, 196.6 g of acrylic block copolymer (manufactured by Kuraray Co., Ltd., trade name "LA4285") as the thermoplastic resin and 98.32 g of tris(2-acryloyloxy ethyl)isocyanurate (manufactured by Hitachi Chemical Company, Ltd., trade name "FA731A") as the (meth)acrylate compound were put. Next, 1.5 g of dicumyl peroxide (manufactured by NOF CORPORATION, trade name "PERCUMYL D") as the polymerization initiator, 843.6 g of silica particles (manufactured by Admatechs Company Limited, trade name "SE2050," volume average particle size: 0.5 $\mu$m) as the inorganic filler, 0.075 g of hindered phenolic polymerization inhibitor (manufactured by ADEKA Corporation, trade name "AO-60") as the polymerization inhibitor, and 288.5 g of methyl ethyl ketone as the solvent were added and mixed under stirring, thereby obtaining a varnish of the thermosetting resin composition. The content of the polymerization inhibitor was 0.08 part by mass with respect to 100 parts by mass of the (meth)acrylate compound.
A sheet for hot pressing was produced in the same manner as in Example 1-1 using the obtained varnish of the thermosetting resin composition. A semiconductor element-mounted substrate for connection evaluation was produced in the same manner as in Example 1-1 using the produced sheet for hot pressing. A semiconductor element-mounted substrate was produced using the sheet for hot pressing on the day of production or the sheet for hot pressing stored in a refrigerated state for 2 weeks or 4 weeks from production.

Example 2-2

A varnish and a sheet for hot pressing were produced in the same manner as in Example 2-1, except that the polymerization inhibitor was changed to p-methoxyphenol (manufactured by Tokyo Chemical Industry Co., Ltd.). A semiconductor element-mounted substrate for connectivity evaluation was produced in the same manner as in Example 2-1 using the obtained sheet for hot pressing.

Example 2-3

A varnish and a sheet for hot pressing were produced in the same manner as in Example 2-1, except that the polymerization inhibitor was not added. A semiconductor element-mounted substrate for connectivity evaluation was produced in the same manner as in Example 2-1 using the obtained sheet for hot pressing.

Comparative Example 2-1

A semiconductor element-mounted substrate for connectivity evaluation was obtained in the same manner as in Example 2-1 using a polyimide film (manufactured by DU PONT-TORAY CO., LTD., trade name "Kapton 100H," average thickness: 25 μm) as the sheet for hot pressing.

Evaluation of connectivity

The inside of the semiconductor element-mounted substrate for connection evaluation was observed using an ultrasonic observation device (manufactured by Insight k.k., trade name, "INSIGHT-300"). The number (NG number) of three power semiconductor elements connected to the copper plate through the sintered metal layer that were observed to have peeling between the copper plate and the sintered metal layer, peeling of the inside of the sintered metal layer, peeling between the sintered metal layer and the power semiconductor element, or sparseness of the sintered metal layer was counted. The results are shown in Table 2. In the semiconductor element-mounted substrates obtained by using the sheet for hot pressing on the day of production in Examples 2-1, 2-2, and 2-3, peeling was not observed. In addition, in the semiconductor element-mounted substrates of Examples 2-1 and 2-2, peeling was not observed even after the sheet for hot pressing was stored for 4 weeks. In the semiconductor element-mounted substrate of Example 2-3, in the case of using the sheet for hot pressing stored for 2 weeks or longer, peeling in the periphery of the connection portion of one power semiconductor element among three power semiconductor elements was observed.

Table 2

| | Example 2-1 | | | Example 2-2 | | | Example 2-3 | | | Comparative Example 2-1 | | |
|---|---|---|---|---|---|---|---|---|---|---|---|---|
| Elapsed days (week) | 0 | 2 | 4 | 0 | 2 | 4 | 0 | 2 | 4 | 0 | 2 | 4 |
| Connectivity (NG number) | 0/3 | 0/3 | 0/3 | 0/3 | 0/3 | 0/3 | 0/3 | 1/3 | 1/3 | 2/3 | 2/3 | 2/3 |

**Reference Signs List**

1: power semiconductor device, 1A: laminate, 3: sheet for hot pressing, 10: wiring substrate, 11: insulating substrate, 13: wiring layer, 20: power semiconductor element, 21: element main body, 23: electrode, 50A: sintering material, 50: sintered metal layer, 41: stage, 43: press-bonding head, 31: thermosetting resin layer, 33a, 33b: release sheet.

**Claims**

1. A method for manufacturing a power semiconductor device including a wiring substrate and a power semiconductor element mounted on the wiring substrate, the method comprising:

a step of heating and pressuring a laminate including a wiring substrate having an insulating substrate and a wiring layer provided on the insulating substrate, a power semiconductor element including an electrode, and a sintering material containing metal particles, the power semiconductor element being disposed so that the wiring layer and the electrode face each other, the sintering material being interposed between the wiring layer and the electrode facing each other, by sandwiching the laminate with a stage and a press-bonding head to thereby electrically connect the wiring layer and the electrode through a sintered metal layer formed by sintering the sintering material, wherein
in the step of electrically connecting the wiring layer and the electrode, the laminate is heated and pressured in a state where a sheet for hot pressing having a thermosetting resin layer is interposed between the laminate and the press-bonding head.

2. The method according to claim 1, wherein the thermosetting resin layer comprises a (meth)acrylate compound and a polymerization inhibitor.

3. The method according to claim 1 or 2, wherein in the step of electrically connecting the wiring layer and the electrode, a plurality of the laminates each having one power semiconductor element or one or a plurality of the laminates having a plurality of the power semiconductor elements disposed one wiring substrate are heated and pressured by being sandwiched with a pair of the stage and the press-bonding head.

4. A sheet for hot pressing comprising a thermosetting resin layer, wherein
   in a step of heating and pressuring a laminate including a wiring substrate having an insulating substrate and a wiring layer provided on the insulating substrate, a power semiconductor element having an electrode, and a sintering material containing metal particles, the power semiconductor element being disposed so that the wiring layer and the electrode face each other, the sintering material being interposed between the wiring layer and the electrode facing each other, by sandwiching the laminate with a stage and a press-bonding head to thereby electrically connect the wiring layer and the electrode through a sintered metal layer formed by sintering the sintering material, the sheet for hot pressing is used for interposing between the laminate and the press-bonding head.

5. The sheet for hot pressing according to claim 4, wherein a thickness of the thermosetting resin layer is 20 $\mu$m or more.

6. The sheet for hot pressing according to claim 4 or 5, further comprising a release sheet provided on one side or both sides of the thermosetting resin layer.

7. The sheet for hot pressing according to any one of claims 4 to 6, wherein the thermosetting resin layer comprises a (meth)acrylate compound and a polymerization initiator.

8. The sheet for hot pressing according to any one of claims 4 to 6, wherein the thermosetting resin layer comprises a (meth)acrylate compound and a polymerization inhibitor.

9. The sheet for hot pressing according to claim 7 or 8, wherein the thermosetting resin layer further comprises an epoxy compound and a curing agent therefore.

10. A thermosetting resin composition for hot pressing comprising a thermosetting resin, the thermosetting resin composition for hot pressing being used for forming the thermosetting resin layer of the sheet for hot pressing according to any one of claims 4 to 6.

11. The thermosetting resin composition for hot pressing according to claim 10, wherein the thermosetting resin composition comprises a (meth)acrylate compound as the thermosetting resin and further comprises a polymerization initiator.

12. The thermosetting resin composition for hot pressing according to claim 10, wherein the thermosetting resin composition comprises a (meth)acrylate compound as the thermosetting resin and further comprises a polymerization inhibitor.

13. The thermosetting resin composition for hot pressing according to any one of claims 10 to 12, further comprising an epoxy compound as the thermosetting resin and a curing agent for the epoxy compound.

14. The thermosetting resin composition for hot pressing according to any one of claims 10 to 13, further comprising a solvent.

# Fig.1

50A

13 11

10

*Fig.2*

*Fig.3*

Fig.4

# Fig.5

Fig.6

*Fig.7*

A

## INTERNATIONAL SEARCH REPORT

International application No.

PCT/JP2018/031678

A. CLASSIFICATION OF SUBJECT MATTER
Int.Cl. H01L21/52(2006.01)i, H01L25/07(2006.01)i, H01L25/18(2006.01)i

According to International Patent Classification (IPC) or to both national classification and IPC

B. FIELDS SEARCHED

Minimum documentation searched (classification system followed by classification symbols)
Int.Cl. H01L21/52, H01L25/07, H01L25/18

Documentation searched other than minimum documentation to the extent that such documents are included in the fields searched
Published examined utility model applications of Japan   1922-1996
Published unexamined utility model applications of Japan   1971-2018
Registered utility model specifications of Japan   1996-2018
Published registered utility model applications of Japan   1994-2018

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2017-121648 A (HITACHI CHEMICAL COMPANY, LTD.) 13 July 2017, paragraphs [0002], [0013]-[0016], [0038]-[0044], fig. 7, 9 (Family: none) | 1-14 |
| Y | JP 2017-45996 A (HITACHI CHEMICAL COMPANY, LTD.) 02 March 2017, paragraphs [0020]-[0076] & EP 3331001 A1, paragraphs [0025]-[0078] | 1-14 |

☒   Further documents are listed in the continuation of Box C.          ☐   See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 18.10.2018 | 30.10.2018 |

| Name and mailing address of the ISA/ | Authorized officer |
|---|---|
| Japan Patent Office 3-4-3, Kasumigaseki, Chiyoda-ku, Tokyo 100-8915, Japan | Telephone No. |

Form PCT/ISA/210 (second sheet) (January 2015)

24

**INTERNATIONAL SEARCH REPORT**

| International application No. |
| --- |
| PCT/JP2018/031678 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | WO 2013/100174 A1 (PANASONIC CORPORATION) 04 July 2013, paragraphs [0018], [0045], [0046], [0065] & US 2015/0299550 A1, paragraphs [0029], [0063], [0064], [0083] | 2, 8, 12 |
| Y | WO 2011/058999 A1 (HITACHI CHEMICAL COMPANY, LTD.) 19 May 2011, paragraphs [0050], [0092], [0093] & US 2012/0248634 A1, paragraphs [0063], [0098], [0099] | 2, 8, 12 |
| A | JP 2014-135411 A (MITSUBISHI ELECTRIC CORPORATION) 24 July 2014, paragraphs [0012]-[0020], fig. 1, 4 (Family: none) | 1-14 |

Form PCT/ISA/210 (continuation of second sheet) (January 2015)

**REFERENCES CITED IN THE DESCRIPTION**

**Patent documents cited in the description**

- JP 2016143685 A